Europäisches Patentamt

European Patent Office

Office européen des brevets

(19)

(11) Veröffentlichungsnummer: **0 110 172 B1**

## (12) EUROPÄISCHE PATENTSCHRIFT

(45) Veröffentlichungstag der Patentschrift:
09.12.87

(51) Int. Cl.⁴: **C 23 C 18/20**

(21) Anmeldenummer: **83110870.9**

(22) Anmeldetag: **31.10.83**

(54) Verfahren zur Herstellung von Verbundwerkstoffen.

(30) Priorität: **13.11.82 DE 3242162**

(43) Veröffentlichungstag der Anmeldung:
**13.06.84 Patentblatt 84/24**

(45) Bekanntmachung des Hinweises auf die Patenterteilung:
**09.12.87 Patentblatt 87/50**

(84) Benannte Vertragsstaaten:
**DE FR GB IT**

(56) Entgegenhaltungen:
**GB - A - 1 109 194**
**US - A - 2 917 439**
**US - A - 3 549 599**

**Die Akte enthält technische Angaben, die nach dem
Eingang der Anmeldung eingereicht wurden und die
nicht in dieser Patentschrift enthalten sind.**

(73) Patentinhaber: **BAYER AG, Konzernverwaltung RP
Patentabteilung, D-5090 Leverkusen 1 Bayerwerk (DE)**

(72) Erfinder: **Sirinyan, Kirkor, Dr., Humperdinckstrasse 12,
D-5060 Bergisch-Gladbach 2 (DE)**
Erfinder: **Jonas, Friedrich, Dr., Krugenofen 15,
D-5100 Aachen (DE)**
Erfinder: **Merten, Rudolf, Dr.,
Berta-von-Suttner-Strasse 55,
D-5090 Leverkusen 1 (DE)**

## Beschreibung

Gegenstand der Erfindung ist ein Verfahren zur Herstellung wärmebeständiger Verbundwerkstoffe, die aus einem Kern, einem damit verbundenen nichtleitenden Polymerfilm und einer darauf aufgebrachten lötfähigen Metallschicht bestehen.

Es ist allgemein bekannt (vgl. z.B. DE-OS 3 123 946) dass derartige Verbundwerkstoffe, wie sie etwa zur Herstellung von gedruckten Schaltungen verwendet werden, dadurch hergestellt werden können, dass man das Kernmaterial mit einem Lack oder einer halbgehärteten Harzlösung behandelt, den dabei erhaltenen Polymerfilm durch Erhitzen vollständig aushärtet und anschliessend mit einem Oxidationsmittel behandelt, bevor die so präparierte Oberfläche – gegebenenfalls nach einer Aktivierung beispielsweise mittels einer Palladiumsalzlösung – einem stromlosen Metallisierungsbad ausgesetzt wird.

Die auf diese Weise hergestellten metallisierten Werkstoffe zeigen jedoch eine Reihe von Nachteilen.

So weisen beispielsweise die Verfahrensprodukte gemäss der vorstehend zitierten Patentpublikation wegen der Kautschukkomponente in dem dort benutzten Polymerfilm keine ausreichende Dauerwärmebeständigkeit in höheren Temperaturbereichen (d.h. oberhalb 140 °C) auf.

Aber selbst beim Einsatz wärmebeständiger Polymermaterialien führen die herkömmlichen Verfahren wegen der Verwendung der starken Oxidationsmittel (beispielsweise Chromschwefelsäure) zu unbefriedigenden Ergebnisse. Durch die Einwirkung dieser Oxidantien, kommt es nämlich auf den Polymerfilmen zur Kavernenbildung, was eine Verschlechterung der physikalischen Eigenschaften (z.B. elektrischer Oberflächenwiderstand und Kriechstromfestigkeit) dieses Werkstoffs zur Folge hat.

Darüber hinaus wird durch die in das Aktivierungs- und Metallisierungsbad von der Chromschwefelsäure eingeschleppten Chromionen eine irreversible Vergiftung dieser Bäder herbeigeführt.

Es wurde deshalb bereits vorgeschlagen (vgl. GB-A 1 109 194 und US-A 2 917 439), dass man auf die bislang übliche oxidative Vorbehandlung bzw. die mechanische Anrauhung der Substratoberflächen verzichten und den auf das Kernmaterial aufgebrachten nicht vollständig ausgehärteten Polymerfilm erst nach der Sensibilisierung mit Zinn-II-chlorid (bzw. sulfat), Aktivierung mit Palladium- oder Goldchlorid und Metallisierung endhärtet.

Es wurde nun gefunden, dass man nach dieser verfahrenstechnisch einfachen Methode eine auf der Filmoberfläche gut haftende Metallauflage mit einer Haftfestigkeit erhält, die auch bei starken Beanspruchungen, wie z.B. beim Löten der elektronischen und/oder elektrischen Bauteile während der Herstellung von gedruckten Schaltungen, praktisch nicht abgelöst werden, wenn man die Aktivierung mit metallorganischen Verbindungen der Elemente der Gruppe Ib oder VIIIa des Periodensystems, deren organischer Teil über die zur Metallbildung erforderlichen Gruppen hinaus wenigstens eine weitere funktionelle Gruppe haben, oder sich von Homo- oder Copolymeren konjugierter Diene oder ungesättigter Polyester ableiten, durchgeführt wird und dass als Polymerfilme solche aus Polyamiden, Polyamidimiden, Polyhydantoinen, Polyimiden oder Polyurethanen verwendet werden.

Für die Erzeugung der Polymerfilme sind solche Polymerisate geeignet, die eine Wärmebeständigkeit für eine Dauer von mindestens 20 Minuten $\geq 140\,°C$ und einen spezifischen elektrischen Oberflächenwiderstand von mindestens $10^{10}\Omega \cdot cm^{-1}$ aufweisen.

Die Herstellung der Polymeren ist allgemein bekannt und kann beispielsweise aus «Grundriss der Makromolekularen Chemie, II, S. 5–45, E. Vollmert-Verlag, Karlsruhe (1979)» entnommen werden.

Ganz besonders bevorzugt sind Polymere auf der Basis von Polyhydantoinen, welche in 5-Stellung des Hydantoinringes eine Essigestergruppierung enthalten. Die Herstellung von diesen Polymerisaten erfolgt nach bekannten Verfahren (vgl. DE-OS 17 20 624 = US-PS 35 49 599) durch Umsetzung von aus Polyaminen und 1,2-Alkylendicarbonsäureestern hergestellten Asparaginestern und Polyisocyanaten und nachfolgender Cyclisierung zu Polyhydantoinen der in jener Patentliteratur angegebenen Formel. Eine weitere Variante dieses Verfahrens ist in der DE-OS 25 39 730 beschrieben, wobei 1,2-Alkylendicarbonsäureester mit Polyharnstoffen zu den entsprechenden Polyhydantoinen umgesetzt werden.

Besonders bevorzugt sind Polyhydantoine, die unter Verwendung von 1,2-Alkylendicarbonsäureesterderivaten mit einer ein- oder mehrfach ungesättigten Alkoholkomponente hergestellt worden sind.

Die eingesetzte Menge dieser ungesättigten 1,2-Alkylendicarbonsäureester kann breit variiert werden und soll 2 bis 100 Mol-% bevorzugt 5–30 Mol-%, bezogen auf die eingesetzte Gesamtester-Menge betragen.

Geeignete funktionelle Gruppen des Aktivators sind Carbonsäuregruppen, Carbonsäurehalogenidgruppen, Carbonsäureanhydridgruppen, Carbonestergruppen, Carbonamid- und Carbonimidgruppen, Aldehyd- und Ketongruppen, Ethergruppen, Sulfonamidgruppen, Sulfonsäuregruppen und Sulfonatgruppen, Sulfonsäurehalogenidgruppen, Sulfonsäureestergruppen, halogenhaltige heterocyclische Reste, wie Chlortriazinyl-, -pyrazinyl-, -pyrimidinyl- oder -chinoxalinylgruppen, aktivierte Doppelbindungen, wie bei Vinylsulfonsäure- oder Acrylsäurederivaten, Aminogruppen, Hydroxylgruppen, Isocyanatgruppen, Olefingruppen und Acetylengruppen sowie Mercaptogruppen und Epoxidgruppen, ferner höherkettige Alkyl- oder Alkenylreste ab $C_8$, insbesondere Olein-, Linolein-, Stearin- oder Palmitingruppen.

Die Aktivierung von Polymerfilmen auf Polyamid- oder Polyesterbasis wird besonders begünstigt durch Aktivatoren, die beispielsweise zusätzliche Carbonyl- oder Sulfonyl-Gruppen besitzen.

Die für die Metallbindung erforderlichen Gruppen des organischen Teiles der metallorganischen Verbindung sind an sich bekannt. Es handelt sich zum Beispiel um C–C– oder C–N–Doppel- und Dreifachbindungen und um Gruppen, die einen Chelat-Komplex ausbilden können, z.B. OH–, SH–, CO–, CS– oder COOH-Gruppen.

Die organometallische Verbindung kann in dem organischen Lösungsmittel beispielsweise gelöst oder dispergiert sein, es kann sich auch um eine Anreicherung der organometallischen Verbindungen mit dem Lösungsmittel handeln.

Ohne den Umfang der Erfindung einzuschränken, empfiehlt sich jedoch, bei der Durchführung des Verfahrens im technischen Massstab folgende Bedingungen einzuhalten:

1. Die verwendeten metallorganischen Verbindungen sollten an der Luft und gegenüber Feuchtigkeit stabil sein. Sie sollten in organischen Lösungsmitteln gut löslich, in Wasser aber schwach löslich sein. Sie sollten ausserdem mit gebräuchlichen Reduktionsmitteln zu einer bei der stromlosen Metallisierung katalytisch wirksamen Verbindung reduzierbar sein.

2. Die Lösungen der metallorganischen Verbindungen in organischen Lösungsmitteln sollten an der Luft und gegenüber Feuchtigkeit stabil sein.

3. Das organische Lösungsmittel sollte leicht entfernbar sein.

4. Bei der Reduktion der organometallischen Verbindung dürfen keine Liganden frei werden, die die Metallisierungsbäder vergiften.

5. Die reduzierten aktiven Keime sollten in wässriger Lösung fest an der Oberfläche haften, um eine Zersetzung der Bäder durch eingeschleppte Metalle zu verhindern.

6. Die verwendeten Aktivierungslösungen sollen nicht den Polymerfilm chemisch oder physikalisch angreifen.

Zur Durchführung des erfindungsgemässen Verfahrens wird eine metallorganische Verbindung von Elementen der Gruppe Ib oder VIIIa des Periodensystems, insbesondere von Cu, Ag, Au, Pd und Pt in einem organischen Lösungsmittel gelöst. Selbstverständlich können auch Mischungen von Verbindungen eingesetzt werden. Die Konzentration an metallorganischer Verbindung soll zwischen 0,01 g und 10 g pro Liter betragen, kann aber in besonderen Fällen auch darunter oder darüber liegen.

Als organische Lösungsmittel sind besonders polare, protische und aprotische Lösungsmittel wie Methylenchlorid, Chloroform, 1,1,1-Trichlorethan, Trichlorethylen, Perchlorethylen, Aceton, Methylethylketon, Butanol, Ethylenglykol und Tetrahydrofuran geeignet.

Selbstverständlich können auch Gemische obiger Lösungsmittel und Verschnitte mit anderen Lösungsmitteln, wie Benzin, Ligroin, Toluol, usw. verwendet werden. Mit diesen Lösungen werden bei dem erfindungsgemässen Verfahren die Oberflächen der zu metallisierenden Substrate benetzt, wobei die Einwirkungsdauer vorzugsweise 1 Sekunde bis 10 Minuten beträgt. Besonders geeignet sind dazu Verfahren wie das Eintauchen des Verbundwerkstoffs in die Lösung oder das Besprühen von Polymeroberfläche mit den Aktivierungslösungen. Ausserdem ist es möglich, die Aktivierungslösungen durch Stempeln oder durch Druckverfahren aufzubringen.

Geeignete funktionelle Gruppen, die sich von Homo- oder Copolymerisaten konjugierter Diene ableiten, sind z.B. Styrol-Butadien-Copolymerisate sowie ungesättigte Polyester, die mit den Metallen, z.B. Palladium, π-Komplexe eingehen.

Mit den beschriebenen Polymerisaten können Träger nach bekannten Verfahren beschichtet werden.

So kann das Kernmaterial durch Extrudieren bzw. durch Beschichten mit einem Polymerfilm versehen werden.

Besonders bevorzugt erfolgt die Beschichtung der Kernschicht aus entsprechender Polymer- bzw. Präpolymerlösung wobei das Lösemittel beim Verhärten dem Polymerfilm entzogen wird.

Eine weitere Variante ist das Besprühen der Kernschicht mit pulverförmigen Präpolymeren, welche beim Verhärten und/oder Tempern teilweise vernetzte Filme bilden. Das Aufbringen von solchen pulverförmigen Prä- oder Hochpolymerisaten an die Kernschichtoberfläche kann nach bekannten Verfahren wie z.B. «Elektrostatisches Pulverversprühverfahren» (EPS) durchgeführt werden.

Als Kernmaterialien für das erfindungsgemässe Verfahren eignen sich organische oder anorganische Substrate, die eine Wärmebeständigkeit für eine Dauer von mindestens 20 Minuten bei 140 °C aufweisen. In diesem Zusammenhang seien Metalle wie z.B. Eisenstähle, Kupfer, Aluminium und Gold, Metallegierungen wie z.B. Bronze, Messing, ferner Glas, Quarz, Keramik, wärmestabile synthetische und/oder natürliche Harze wie z.B. Phenol-Formaldehydharze, Melaminharze, Polyamide, Polyester, Polycarbonate, Polyacrylnitril, Polyvinylchlorid, sowie deren Mischungen oder aus Mischpolymerisaten der genannten Monomeren genannt.

Selbstverständlich können die oben aufgeführten Polymerisate mit den üblichen Füllstoffen wie Glasfasern, Kohlefasern, Aramidfasern, Russ oder Talkum versetzt werden.

In besonderen Fällen können Kern und Polymerfilm aus den obengenannten bevorzugt zu verwendenden Polymerisaten hergestellt werden. So können beispielsweise Glasfaser-, Aramidfaser- oder Kohlefasermatten und/oder ihre Gemische untereinander mit Prä- oder Endpolymerisaten, die zur Durchführung des erfindungsgemässen Verfahrens geeignet sind, getränkt, nach der physikalischen oder chemischen Trocknung der Polymermatrix gegebenenfalls mit einem Polymerfilm, welcher aus dem gleichen Polymerisat besteht, beschichtet und dann erfindungsgemäss haftfest metallisiert werden.

Im allgemeinen kann die Schichtdicke des vorgehärteten und/oder halbgehärteten Polymerfilms zwischen 2 µm und 200 µm liegen, wobei die

Schichtdicken von 5 bis 100 μm bevorzugt von 15 μm bis 50 μm besonders bevorzugt werden.

Die Vor- bzw. Endhärtungsbedingungen für die Polymerfilme hängen bekanntlich von ihrem chemischen Aufbau ab. Im allgemeinen werden die Polymerisate 2–60 Minuten vorzugsweise 5 bis 30 Minuten bei einer Temperatur von 90–400 °C vorzugsweise 100–350 °C besonders bevorzugt 150 bis 300 °C behandelt. Selbstverständlich können die zur Durchführung des erfindungsgemässen Verfahrens geeigneten Systeme mit Katalysatoren versetzt werden, wobei durch die Wahl von geeigneten Katalysatoren die Verhärtungs- bzw. Endhärtungsbedingungen bezüglich Zeit und Temperatur nach unten oder gegebenenfalls nach oben variiert werden können.

Im allgemeinen soll der Härtegrad des nicht vollständig ausgehärteten zu metallisierenden Polymerfilms 30 bis 80% des nach der Endhärtung erzielbaren Härtegrads betragen.

Vorzugsweise erfolgt die Endhärtung im Erweichungsbereich des Polymerfilms bzw. Elektroisolierlackes.

Bei der praktischen Durchführung des erfindungsgemässen Verfahrens wird im allgemeinen folgendermassen vorgegangen. Die zu metallisierenden Substrate werden mit einem Polymerfilm versehen, der gegebenenfalls nach der Befreiung von Lösungsmitteln bei erhöhten Temperaturen vorgehärtet und dann mit einer kolloidalen oder ionogenen, wässrigen Lösung der Elemente der 1. und 8. Nebengruppe des Periodensystems aktiviert, von überschüssigen Aktivierungskeimen befreit und gegebenenfalls durch Behandlung mit salzsaurer Sn–II–Cl$_2$–Lösung sensibilisiert wird. Eine andere elegante, technisch einfach durchführbare Aktivierung der Lackoberflächen kann mit Hilfe von bestimmten organometallischen Verbindungen der Elemente der Gruppe Ib oder VIIIa vorgenommen werden.

Diese ganz besonders bevorzugte Aktivierungsform des erfindungsgemässen Verfahrens besteht darin, dass die Sensibilisierung der Aktivierungskeime im Metallisierungsbad gleich mit dem Reduktionsmittel der stromlosen Metallisierung durchgeführt wird.

Diese Verfahrensvariante ist ganz besonders für aminoboranhaltige Nickel- oder Cobaltbäder oder formalinhaltige Kupferbäder geeignet.

Die so aktivierten Oberflächen können direkt zur stromlosen Metallisierung eingesetzt werden.

Als in dem erfindungsgemässen Verfahren einsetzbare Metallisierungsbäder kommen bevorzugt Bäder mit Nickelsalzen, Cobaltsalzen, Kupfersalzen, Gold- und Silbersalzen oder deren Gemische untereinander oder mit Eisen-, Mangan- und Wolframsalzen in Betracht. Derartige Metallisierungsbäder sind in der Technik der stromlosen Metallisierung bekannt.

Die Schichtdicke der chemisch abgeschiedenen Metallauflagen soll vor ihrer Temperung im Bereich von 0,01 bis zum 5,0 μm liegen, wobei sie in besonderen Fällen nach oben variiert werden kann.

Nach der Metallabscheidung werden die Probekörper gegebenenfalls mit Wasser gewaschen, von Salzen und Reduktionsmitteln befreit und dann vorzugsweise bei Vorhärtungsbedingungen 2 bis 60 Minuten, besonders bevorzugt 5 bis 30 Minuten getempert und endgehärtet. In besonderen Fällen kann eine Endhärtung bzw. Nachtemperung in einer Inertgasatmosphäre vorgenommen werden. Gewünschtenfalls können solche Metallauflagen auf chemischem oder galvanischem Wege beliebig verstärkt werden.

Die erfindungsgemässen Verfahrensprodukte sind vielseitig anwendbar, beispielsweise bei der Herstellung von gedruckten elektrischen Schaltungen (Leiterplatten) nach dem Semiadditiv-Verfahren, Volladditiv-Verfahren, Metallresist-Verfahren, Substraktiv-Additiv-Verfahren oder der Multilayertechnik (vgl. R. Weiner, «Kunststoffgalvanisierung», Eugen G. Lenze-Verlag, Saulgau/ Württemberg (1973)). Die neue Erfindung wird durch die nachfolgenden Beispiele näher erläutert, ohne deren Umfang dadurch einzuschränken.

Beispiel 1

Eine 50 × 200 × 2 mm Blechplatte wird mit einer Polyhydantoinlacklösung durch Tauchen beschichtet, bei 240 °C 15 Minuten vorgehärtet. Der so erhaltene ca. 20 μm starke Lackfilm wird in eine Aktivierungslösung aus 1,50 g 8-Octadien-1-olpalladiumdichlorid in 1 ltr. Methanol getaucht und dann in einem 1 ltr. Vernickelungsbad, welches 3,5 g Dimethylaminoboran, 30 g Nickelchlorid und 10 g Citronensäure enthält und mit konzentriertem Ammoniak auf pH 8,2 eingestellt ist, stromlos vernickelt.

Nach etwa einer Minute färbt sich die Probekörperoberfläche dunkel und nach 10 Minuten ist der Probekörper mit einer glänzenden elektrisch leitenden 0,2 μm starken Ni-Schicht versehen.

Nun wird der Probekörper dem Metallisierungsbad entnommen, mit destilliertem Wasser gewaschen und bei 250 °C 10 Minuten im Trockenschrank endgetempert. Man erhält einen Vierschicht-Verbundwerkstoff, dessen Metallauflage so fest an der Lackoberfläche verankert ist, dass bei der Durchführung der Abzugsfestigkeit nach DIN 53 494 keine Abschälung erfolgt.

Die oben erwähnte Präpolymerlösung wurde wie folgt hergestellt:

58,8 g Maleinsäurediallylester und 100,8 g Maleinsäuredimethylester werden in 300 ml Glykolmonomethyletheracetat vorgelegt. Unter Rühren werden bei 0–5 °C 58 g Hexamethylendiamin in 50 ml Methanol zugetropft. Anschliessend wird 24 Stunden bei Raumtemperatur gerührt. Nach Zugabe von 300 g Glykolmonomethyletheracetat werden portionsweise bei Temperaturen unter 50 °C 131,4 g 4,4′-Diisocyanatodiphenylmethan zugesetzt. Es wird 2 Stunden bei 100 °C gerührt, 100 g Benzylalkohol zugetropft und dann 10 h bei Rückfluss gerührt, wobei gebildetes Methanol abdestilliert.

Nach dem Abkühlen erhält man eine klare viskose Lösung mit einem Feststoffgehalt von 29%.

## Beispiel 2

Ein gemäss Beispiel 1 mit einem Polymerfilm versehener Verbundwerkstoff aus einem 300 × 100 × 1 mm grossen Messingkern wird in einem handelsüblichen, kolloidalen und salzsauren Palladiumsolbad aktiviert, in einer salzsauren $Sn^{2+}$-Lösung sensibilisiert und dann in einem üblichen chemischen Ni-Hypophosphitbad bei 85 °C 20 Minuten metallisiert, mit destilliertem Wasser gewaschen und dann gemäss Beispiel 1 endgehärtet.

Man bekommt einen Vierschicht-Verbundwerkstoff aus einem Metallkern mit zwei elektrisch nicht leitenden Isolatorschichten, an deren Oberfläche die auf chemischem Wege abgeschiedene Metallauflage fest verankert ist. Ihre Reissfestigkeit ist trotz einer galvanischen Verstärkung auf 40 µm geringer als ihre Haftfestigkeit.

## Beispiel 3

Eine 200 × 20 × 3 mm grosse glasfaserverstärkte Epoxidharzplatte wird mit einer 25%igen Polymerlösung gemäss Beispiel 1 in Glykolmonomethyletheracetat/Benzylalkohol (50:50 Vol-%) durch Tauchen beschichtet. Nach der physikalischen Trocknung der Polymerschicht wird die Platte bei 200 °C 20 Minuten getempert und dann in einer Aktivierungslösung aus 0,7 g Butadienpalladiumchlorid in 1 ltr. 1,1,1-Trichlorethan bei 25 °C 3 Minuten aktiviert, bei 35 °C getrocknet, in einem chemischen Kupferbad der Fa. Shipley GmbH, Stuttgart, bei 30 °C 20 Minuten metallisiert und dann bei 200 °C 30 Minuten endgetempert. Die so an die Probekörperfläche aufgebrachte Metallauflage hat eine solch hohe Abzugsfestigkeit, dass ihre Messung nach DIN 53 494 nicht möglich ist.

## Beispiel 4

Eine kohlenfaserverstärkte hochtemperaturbeständige Polyimid-Amidplatte wird mit einer 30 gew.-%igen Präpolymerlösung auf der Basis von oligomerem Polyimid in Kresol, welche nach US-PS 31 79 614 hergestellt wird, bei 40 °C beschichtet, das Lösemittel bei 80 °C der Polymerschicht entzogen, der Probekörper 20 Minuten bei 230 °C vorgehärtet, gemäss Beispiel 3 aktiviert, nach Beispiel 1 in einem chemischen Metallisierungsbad vernickelt und dann bei 240 °C 15 Minuten die Polymerschicht endhärtet. Die Abzugsfestigkeit der Metallauflage nach ihrer galvanischen Verstärkung beträgt ~80 N/25 mm.

## Beispiel 5

Eine 200 × 40 × 1 mm grosse Aluminiumplatte wird mit 0,5 mm grossen Löchern versehen, mit einer handelsüblichen präpolymeren Hydantoinlösung (25% in Kresol) mit dem Handelsnamen Resistern PHIO der Fa. Bayer AG, Leverkusen, beschichtet, das Lösemittel bei 50 °C dem Polymerfilm entzogen und dann bei 260 °C 18 Minuten getempert. Die so erhaltene ca. 30 µm starke Polymerschicht wird gemäss Beispiel 1 aktiviert, getrocknet, mit einer Maske auf der Basis von Styrolbutadiencopolymerisat, welche freie kammförmige Bahnen von etwa 1 mm Breite aufweist, bedeckt und dann gemäss Beispiel 1 stromlos vernickelt.

Nach etwa einer Minute färben sich die freien Bahnen dunkel und nach ca. 10 Minuten wird eine metallisch glänzende 0,2 µm starke Ni-Schicht abgeschieden, die mit galvanischem Kupfer auf 40 µm verstärkt wird.

Man bekommt eine durchkontaktierte elektrische Leiterbahnplatte mit 1 mm breiten und 40 µm starken Leiterbahnen. Die Metallschicht haftet an der Substratoberfläche so gut, dass sie trotz einer 30-minütigen Nachtemperung bei 240 °C nicht von der Substratoberfläche zu entfernen ist.

## Beispiel 6

Eine 20 × 200 × 2 mm grosse graphitfaserverstärkte Phenolharzplatte wird mit einem handelsüblichen, zweikomponenten DDN-Lack mit dem Handelsnamen Emalit der Fa. Bullig und Kemper, Köln, versehen, die Lackschicht wird 15 Minuten bei 80 °C vorgehärtet, gemäss Beispiel 3 aktiviert, gemäss Beispiel 1 vernickelt, mit destilliertem Wasser gewaschen und dann unter $N_2$-Atmosphäre bei 130 °C 15 Minuten getempert. Man bekommt einen Verbundwerkstoff, dessen Ni-Auflage eine Abzugsfestigkeit nach DIN 53 494 ca. 75 N/25 mm aufweist.

## Beispiel 7

Eine gemäss Beispiel 5 mit einem Polymerfilm versehene 20 × 20 × 1 mm grosse Kupferfolie wird in einem Aktivierungsbad, welches aus 0,5 g 4-Cyclohexen-1,2-dicarbonsäureanhydridpalladiumchlorid und 500 ml Methanol besteht, im Verlaufe von 20 Sekunden aktiviert und dann in einem wässrigen Verkupferungsbad, das in 1 ltr. 10 g $CuSO_4$, 15 g Seignette-Salz, 20 ml 35 gew.-%ige Formalinlösung enthält und mit 32 gew.-%iger NaOH-Lösung auf pH 12 bis 13 eingestellt ist, bei 20 °C stromlos verkupfert und dann gemäss Beispiel 5 getempert.

Man bekommt eine Mehrschichtverbundfolie aus Kunststoff und Kupfer. Die chemische Cu-Schicht haftet an der Polymerschicht so stark, dass eine Durchführung einer Abzugsfestigkeitsmessung nach DIN 53 494 nicht möglich ist.

## Beispiel 8

Eine gemäss Beispiel 5 mit Löchern versehene und einer Polymerschicht überzogene Al-Platte wird gemäss Beispiel 7 aktiviert, gemäss Beispiel 1 vernickelt, gemäss Beispiel 5 endgetempert. Die so erhaltene, haftfeste Metallauflage wird mit einem UV-härtbaren Lack auf der Basis von oligomerem 1,4-Polyisopren (~5 gew.-%ig in Xylol) mit lichtempfindlichem Diazol-Initiator besprüht, die Lackschicht mit einer Maske bedeckt und mit Hilfe von UV-Bestrahlung partiell ausgehärtet. Der nicht ausgehärtete Polymeranteil wird nach Entfernen der Maske vom Probekörper in Methanol (reinst) entfernt. Die UV-Lackfreie Ni-Auflage wird vom Probekörper durch Behandlung in einer schwefelsauren, $Fe^{3+}$-haltigen Ätzlösung ausgeätzt und dann mit destilliertem Wasser gewaschen. Man enthält ein mit 0,2 µm starken, gut haftenden elektrisch leitenden Bahnen versehenes Verbundmaterial.

**Beispiel 9**

Eine 200 × 100 × 1 mm starke Aluminiumfolie wird mit einer bei 250°C unter N₂-Atmosphäre vorkondensierten 30 gew.-%igen Lösung aus 1 Mol Pyromellithsäuredianhydrid und 1 Mol 4,4'-Diaminodiphenylether in trockenem Dimethylacetamid durch Tauchen beschichtet, bei 250°C 10 Minuten vorgehärtet. Der so erhaltene ca. 20 μm starke Polymerfilm wird nach Beispiel 3 aktiviert, gemäss Beispiel 1 metallisiert, mit destilliertem Wasser gewaschen und dann bei 270°C 8 Minuten endgehärtet. Man bekommt ein Mehrschichtverbundwerkstoff, dessen auf chemischem Wege abgeschiedene Nickelauflage eine Haftfestigkeit, bestimmt durch die Abzugskraft nach DIN 53 494, ∼75 N/25 mm aufweist.

**Beispiel 10**

Eine 150 × 100 × 10 mm starke glasfaserverstärkte Kunststoffplatte aus Polyamid 6.6 wird mit einer käuflich erhältlichen Präpolymerlösung auf der Basis von Polyamidimid durch Tauchen beschichtet, bei 250°C 10 Minuten vorgehärtet. Der so erhaltene ca. 30 μm starke Polymerfilm gemäss Beispiel 3 aktiviert, gemäss Beispiel 1 metallisiert und dann bei 265°C 7 Minuten getempert.

Man bekommt eine glänzende, gut haftende Ni-Auflage, deren Abzugsfestigkeit nach DIN 53 494 ∼80 N/25 mm beträgt.

**Patentansprüche**

1. Verfahren zur Herstellung eines lötfähigen metallisierten Verbundwerkstoffs zur Herstellung von gedruckten Schaltungen durch (a) Beschichten eines lötbeständigen Kernmaterials mit einem nicht vollständig ausgehärteten Polymerfilm, (b) Aktivieren mit Verbindungen der Elemente der Gruppe Ib oder VIIIa des Periodensystems ohne oxidative Vorbehandlung und ohne mechanische Anrauhung sowie (c) nasschemische Metallisierung dieses Polymerfilms und anschliessende (d) Endaushärtung, dadurch gekennzeichnet, dass die Aktivierung mit solchen metallorganischen Verbindungen der Elemente der Gruppe Ib oder VIIIa deren organischer Teil über die zur Metallbildung erforderlichen Gruppen hinaus wenigstens eine weitere funktionelle Gruppe haben, oder sich von Homo- oder Copolymeren konjugierter Diene oder ungesättigter Polyester ableiten, durchgeführt wird und dass als Polymerfilme solche aus Polyamiden, Polyamidimiden, Polyhydantoinen, Polyimiden oder Polyurethanen verwendet werden.

2. Verfahren nach Anspruch 1, dadurch gekennzeichnet, dass als Polymerfilme Polyhydantoine verwendet werden, die in Endstellung, Seitenketten und/oder Hauptkette Doppelbindungen enthalten.

**Claims**

1. Process for the production of a solderable metallised composite material for the production of printed circuits by (a) coating a solder-resistant core material with an incompletely cured polymer film, (b) activating the latter, without oxidative pretreatment and without mechanical roughening, with compounds of the elements of group Ib or VIIIa of the periodic system and (c) wet-chemically metallising this polymer film and subsequently (d) completing the curing process, characterised in that the activation is carried out with those organometallic compounds of the elements of group Ib or VIIIa whose organic part contains at least one further functional group in addition to the groups required for metal formation or which are derived from homo- or copolymers of conjugated dienes or unsaturated polyesters, and in that the polymer films used are those obtained from polyamides, polyamidoimides, polyhydantoins, polyimides or polyurethanes.

2. Process according to Claim 1, characterised in that polyhydantoins containing couble bonds in the end position, side chains and/or main chain are used as the polymer films.

**Revendications**

1. Procédé de production d'un matériau composite métallisé apte au soudage pour la production de circuits imprimés, par (a) revêtement d'un matériau central stable au soudage avec un film de polymère non entièrement durci, (b) activation avec des composés des éléments du Groupe Ib ou VIIIa du Tableau Périodique sans pré-traitement par oxydation et sans opération mécanique le rendant rugueux, ainsi que (c) métallisation chimique par voie humide de ce film de polymère suivie (d) d'un durcissement final, caractérisé en ce que l'activation est effectuée avec des composés organométalliques des éléments du Groupe Ib ou du Groupe VIIIa dont la partie organique porte, en plus des groupes nécessaires pour la métallisation, au moins un autre groupe fonctionnel, ou est dérivée d'homopolymères ou de copolymères de diènes conjugués ou de polyesters insaturés, et en ce qu'on utilise comme films de polymère des films de polyamides, de polyamide-imides, de polyhydantoïnes, de polyimides ou de polyuréthannes.

2. Procédé suivant la revendication 1, caractérisé en ce qu'on utilise comme films de polymère des polyhydantoïnes qui comportent des doubles liaisons en position terminale, dans les chaînes latérales et/ou dans la chaîne principale.